**Europäisches Patentamt**

(19) **European Patent Office**

**Office européen des brevets**

(11) Publication number : **0 347 058 B1**

(12) **EUROPEAN PATENT SPECIFICATION**

(45) Date of publication of patent specification :
31.08.94 Bulletin 94/35

(51) Int. Cl.⁵ : **H05K 3/28, B05D 1/02**

(21) Application number : **89305377.7**

(22) Date of filing : **26.05.89**

(54) **Method for applying a moistureproof coating to printed circuit boards.**

(30) Priority : **13.06.88 US 206199**

(43) Date of publication of application :
**20.12.89 Bulletin 89/51**

(45) Publication of the grant of the patent :
**31.08.94 Bulletin 94/35**

(84) Designated Contracting States :
**AT BE CH DE ES FR GB GR IT LI LU NL SE**

(56) References cited :
**EP-A- 0 230 782**
**US-A- 4 337 281**

(73) Proprietor : **NORDSON CORPORATION**
**28601 Clemens Road**
**Westlake, OH 44145 (US)**

(72) Inventor : **Shimada, Takaji**
**2-15-15-610 Hon-cho**
**Kawaguchi City Saitoma Prefecture (JP)**

(74) Representative : **Allen, Oliver John Richard et al**
**Lloyd Wise, Tregear & Co.**
**Norman House**
**105-109 Strand**
**London, WC2R 0AE (GB)**

EP 0 347 058 B1

## Description

This invention relates to the coating of moistureproof insulator films on printed circuit boards to protect the circuit boards from moisture, electric leakage and dust. Preferably, the moistureproof insulator films are what are known as "humiseal" coatings, such as, acryl, polyurethane, or epoxy synthetic resins dissolved in a volatile solvent. When applied to clean printed circuit boards, a uniform thickness insulative resin film, without pinholes, is formed as the solvent evaporates on a continuous basis.

In the past, five principal methods have been used to apply coatings of moistureproof insulators to printed circuit boards. These included the following:

a) The immersion method, in which packaged circuit boards are immersed in an immersion tank containing the moistureproof insulator.

b) The brush-coating method, in which the moistureproof insulator is applied by a brush to the printed circuit board surface to be coated.

c) The roller method, in which a sheep's wool roll impregnated with the moistureproof insulator is rolled on the surface of the printed circuit board to thereby provide the insulative coating thereon.

d) The spray method, in which the moistureproof insulator is applied to the printed circuit board by spraying techniques.

e) The slit die method, in which the moistureproof insulator is pressurized and extruded from a slit die to eject a film for coating the printed circuit board surface.

Each of the foregoing methods have certain advantages and disadvantages. For example, all methods except brush-coating require masking for those parts to be left uncoated. The masking operations, that is, mounting and removal of the masks, must be done manually, causing a bottleneck in the mass production process. Brush-coating, while not requiring masking, is labor-intensive, and otherwise unsuitable for mass production.

The most commonly used insulative coating method is the spraying method. Spraying can be categorized as either air spraying in which an air stream is impinged against the stream of liquid coating material to atomize it, and airless spraying in which atomization of the coating material is achieved by subjecting the liquid coating material to very high pressures such that after emission from the nozzle it becomes atomized. In air spraying almost no liquid droplets are in the spray pattern ejected from the nozzle. Whereas, in airless spraying, especially in flat pattern spraying, a small quantity of liquid can be seen in the form of a triangular or dovetail-shaped liquid film near the nozzle opening, which extends from the nozzle a distance D. This liquid film is referred to as a "dovetail" or "tail". Beyond the distance D, atomization occurs. Depending upon the pressure used to eject the liquid coating from the airless nozzle, which typically ranges between $40Kg/cm^2$ and $80Kg/cm^2$, and the viscosity of the coating material, the length D of the dovetail or triangular liquid film generally approximates 5mm-8mm.

Illustrative of prior patents disclosing the coating of articles with a 5mm-8mm dovetail or triangular liquid film from an airless spray nozzle operating pressure of $40Kg/cm^2$ or more are U.S. 3,852,095 and U.S. 4,337,281. U.S. 3,852,095 discloses the application of a film of wax to the rim of a can end before the end is assembled to the body of a can. U.S. 4,337,281 discloses striping the inside seam of welded cans to protect the contents of the can against metal contamination.

Airless spray coating of insulative material on printed circuit boards, with the 5mm-8mm length dovetail or triangular liquid film produced using pressures in excess of $40Kg/cm^2$ has produced certain problems. These include splashing, nonuniformity in coating thickness, and a width for the strip-like coating which is relatively narrow. Also, since the distance between the nozzle and the substrate to be coated is relatively short, it is difficult to coat printed circuit boards, especially those with varying height circuit components mounted thereon which afford a non-flat surface.

European Patent Application 0230782 describes a method which allows printed circuit boards to be coated with an insulator coating of surprisingly high quality in terms of coating thickness uniformity and the absence of splashing, by supplying the liquid coating material to an airless flat-patterned nozzle at a supply pressure, e.g., $2Kg/cm^2$ for a 100cps viscosity coating, such that a liquid film emission from the nozzle is produced in the form of a flat leaf pattern. The leaf-shaped liquid film, which is substantially free of atomized particles, has a maximum width $W_a$ at its approximate center, which decreases on both sides of the center to an approximately zero width at a distance $L_a$ from the center. The nozzle and printed circuit board are positioned at a specified distance apart relative to each other to locate the circuit board in the path of the flat leaf-shaped liquid film pattern, preferably at the distance $L_a$ from the nozzle where the width of the leaf-shaped liquid film is at its maximum width $W_a$.

The aforesaid European Patent Application 0230782 discloses that 100cps viscosity insulator coating when subjected to pressures of $50Kg/cm^2$, $20Kg/cm^2$, $10Kg/cm^2$ and $5Kg/cm^2$ produces dovetail or triangular liquid film patterns, in contrast to leaf-shaped liquid film patterns of the type described in the preceding paragraph, having liquid film lengths of 5mm, 8mm, 9mm, and 12mm, respectively. The same dovetail or triangular liquid film lengths of 5mm, 8mm, 9mm, and 12mm can be achieved with an insulator coating viscosity of 50cps at pressures of 35Kg/cm$^2$, 12Kg/cm$^2$, 5Kg/cm$^2$ and 3Kg/cm$^2$, respectively. Dovetail or triangular liquid films of the foregoing type, designated F1, F2, F2, and F4, are depicted in Figs. 8, 9, 10 and 11, respectively, of the above-referenced European Patent Application No. 0230782.

As noted in European Patent Application 0230782, splashing occurred when the film F4 of Figure 11 thereof was used to coat the surface of a printed circuit board. This was attributed to the liquid ejection pressure of 5Kg/cm$^2$. Splashless coating occurred only when the liquid pressure of a 100 cps viscosity coating lowered to 2Kg/cm$^2$ and the dovetail or triangular film changed to a "leaf" shape Fs, such as shown in Figure 13A in the above mentioned European Patent Application.

In accordance with the invention, a method of applying moistureproof insulative coating to selected areas of a circuit board without applying insulative coating to regions to be left uncoated, comprising supplying insulative liquid coating material to a flat-pattern nozzle means at a supply pressure such as to produce a liquid film emission from the nozzle means in a flat pattern, positioning the nozzle means and circuit board at a specified distance apart relative to each other to position the circuit board in the path of the flat pattern, producing relative movement between the nozzle means and circuit board in a direction generally transverse to the plane of the flat pattern, and controlling the liquid coating supply during relative movement between the nozzle means and circuit board to a) supply liquid to the nozzle means when the flat pattern is directed toward the selected areas to be coated to impinge a flat liquid film thereon and thereby coat the areas to be coated, and b) interrupt the supply of liquid to the nozzle means when the flat pattern is directed toward the regions to be left uncoated to terminate emission of the flat liquid film and prevent deposit thereof on the regions to be left uncoated characterised in that the insulative liquid coating material is supplied to the nozzle means at a supply pressure up to 8 kg/cm$^2$ so that the flat pattern of the liquid film emission has a generally triangular shape with a lower horizontal base edge and an upper apex, which has a maximum width W at its lower base edge below which discrete liquid droplets of coating begin to form, and which decreases in width to an approximately zero width at a distance L above the lower base edge, the triangular shaped liquid film being substantially free of atomised particles of coating and in that the specified distance between the nozzle means and the circuit board does not exceed a distance of approximately 2/3 L.

The method allows splashless uniform-thickness coatings of insulator material to be provided on printed circuit boards with dovetail or triangular-shaped liquid films emitted from an airless flat-pattern spray nozzle Where the distance between the nozzle and the printed circuit board to be coated is approximately 10 mm or less, suitable discharge pressures equivalent to approximately 8Kg/cm$^2$ or less are employed with insulative coatings having viscosities in the approximate range of 125-155 cps and substantially splash-free uniform thickness coatings can be deposited. As the nozzle-to-substrate distance increases from 10 mm to 20 mm, splash-free uniform thickness coatings can be achieved by decreasing the discharge pressure from a pressure equivalent to 6Kg/cm$^2$ for a 125 cps viscosity coating to a pressure equivalent to 2.7Kg/cm$^2$ for a 125 cps viscosity coating.

The pressure and viscosity of the coating are selected to produce a triangular or dovetail shaped liquid film, and the distance between the nozzle and the surface of the printed circuit board to be coated is selected such that it does not exceed approximately two-thirds "L", where "L" is the distance between the nozzle and the horizontal base edge of the dovetail or triangular liquid film below which the solid liquid film begins to break up into droplets to form an atomized spray.

The invention will now be further described by way of example with reference to the accompanying drawings in which:-

Fig. 1 illustrates the application of coating bands in parallel by a single flat spray pattern airless nozzle according to the invention.

Fig. 2 illustrates the operation of the invention for coating only selected portions of a printed circuit board and leaving other portions uncoated.

Fig. 3 illustrates the operation of the invention using multiple flat pattern airless nozzles to concurrently apply multiple bands of coating material to a printed circuit board.

Fig. 4A is a front view of an emission from a flat spray pattern airless nozzle showing the triangular or dovetail shaped liquid portion below which it breaks up into droplets to form an atomized spray.

Fig. 4B is a side view of the airless nozzle emission of Fig. 4A.

Fig. 5 is a perspective view of a flat spray pattern airless nozzle for producing the emission pattern of Figs. 4A and 4B, viewed from below at an oblique angle.

Fig. 6 is a front view of the spray pattern from a flat spray pattern airless nozzle for a liquid with a viscosity of 100cps at 50Kg/cm$^2$.

Figs. 7, 8 and 9 are front views of spray patterns from a flat pattern airless nozzle for 100cps viscosity liquid at pressures of 20Kg/cm², 10Kg/cm², and 5Kg/cm², respectively.

Fig. 10A is a front view of a leaf-shaped film at 2Kg/cm² for a 100cps insulator coating liquid.

Fig. 10B is the side view of the leaf-shaped film of Fig. 10A.

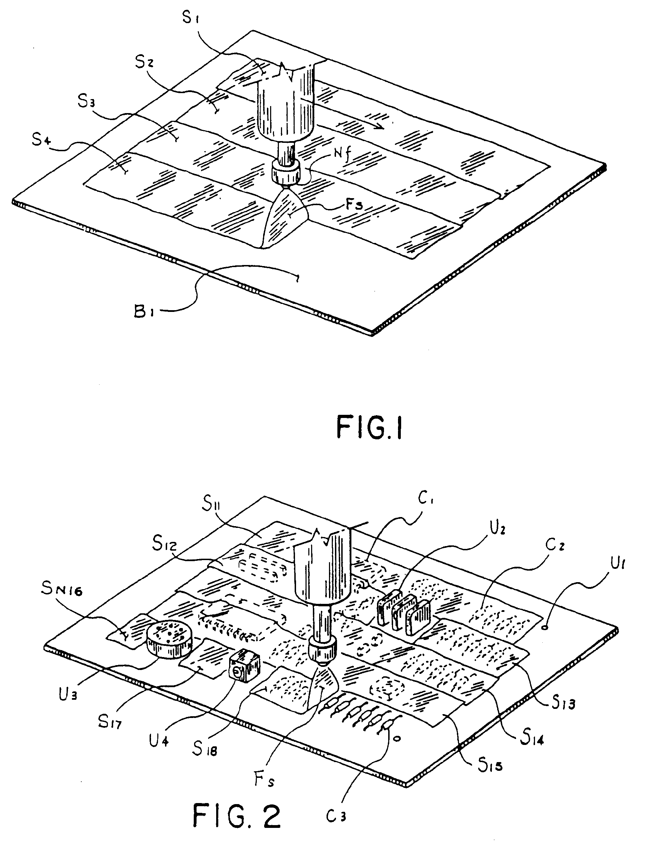

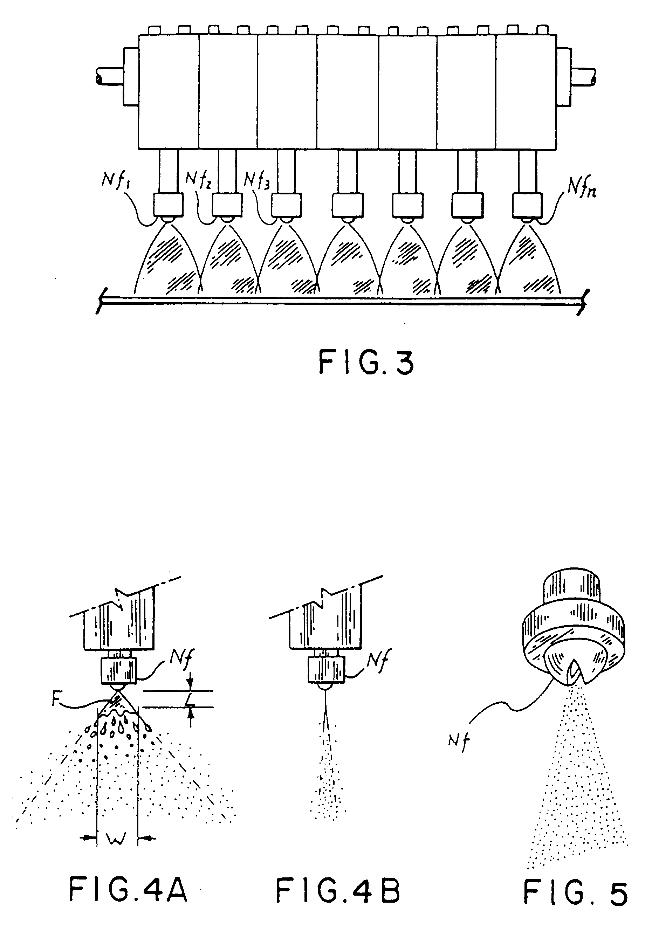

As shown in Fig. 1, a substrate of a printed circuit board B1 having circuit components (not shown) thereon is disposed is a generally horizontal plane below a flat fan spray airless nozzle Nf which is adapted to selectively move in orthogonal coordinate directions with respect to the printed circuit board. To provide bands of insulator coating material S1, S2, S3 and S4 on the printed circuit board B1, a triangular or dovetail shaped liquid film Fs is emitted from the nozzle Nf as relative motion between the nozzle and the printed circuit board occurs. With reference to Fig. 2, by selectively terminating and initiating emission of the dovetail or triangular liquid film emitted from the airless nozzle Nf, printed circuit board components U1, U2, U3 and U4 can be left uncoated while components C1, C2 and the like can be coated by applying, on a sequential basis, coating bands S11, S12, S13, S14, S15, S16, S17 and S18. If desired, and with reference to Fig. 3, plural airless nozzles $Nf_1$, $Nf_2$ $NF_3$...$NF_n$ can be used to simultaneously apply plural bands of coating material to a printed circuit board or other substrate.

As shown in Fig. 4A and 4B, when pressurized insulator coating material is emitted from an airless flat-pattern spray nozzle Nf a triangular or dovetail shaped flat liquid film F is produced. The liquid film F has a maximum width W at its lower base edge below which discrete liquid droplets of coating begin to form to eventually provide an atomized cloud of coating material. The width W of the lower base edge of the triangular liquid coating film F decreases from a maximum width at the lower base edge thereof to a width of approximately zero at the upper corner or apex of the triangular film F approximately at the orifice of the nozzle Nf. The height of the triangular liquid film F measured in a vertical direction, which is referenced with the letter L, is a function of the viscosity and pressure applied to the liquid coating. For a given viscosity coating material, the length L of the triangular film F decreases as the pressure is increased. In conventional airless coating applications, wherein pressures are typically in the range of 40 Kg/cm² to 80 Kg/cm², the triangular film height is approximately 5 mm - 8 mm for a typical coating.

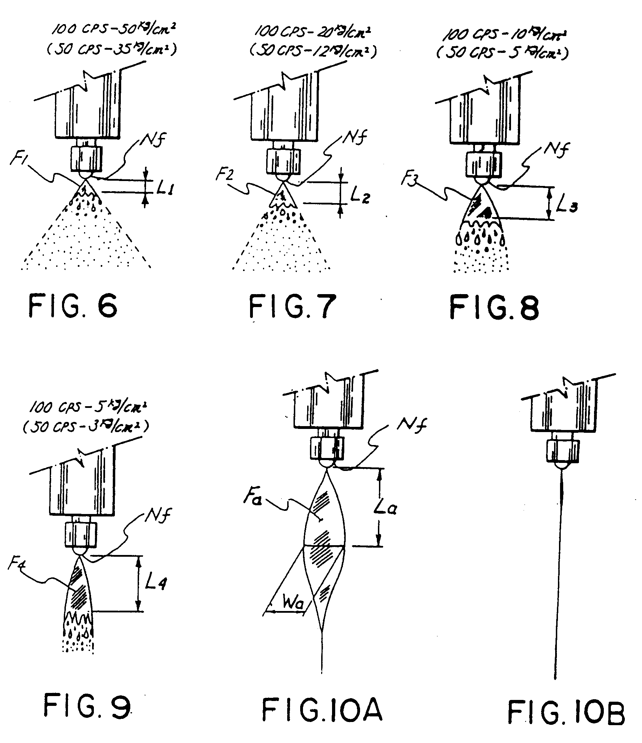

With reference to Figures 6 - 9, triangular films $F_1$, $F_2$, $F_3$, and $F_4$ are shown of increasing triangular film lengths $L_1$, $L_2$, $L_3$ and $L_4$, respectively, for 100 cps insulated coating material at pressures of 50 Kg/cm², 20 Kg/cm², 10 Kg/cm² and 5 Kg/cm², respectively. If the pressure applied to the 100 cps viscosity insulator coating material is reduced to 2 Kg/cm² the liquid film converts from a triangular form (such as $F_1$, $F_2$, $F_3$ and $F_4$ shown in Figures 6 - 9) to a leaf-shaped liquid film $F_a$ which has a maximum width $W_a$ at its approximate center and which decreases in width on both sides of the center to an approximately zero width at a distance $L_a$ on each side of the center, with the leaf-shaped film $F_a$ being substantially free of atomized particles of coating. A leaf-shaped liquid film of insulated coating material is shown in Figures 10A and 10B.

According to European Patent Application 0230782 a uniform thickness coating can be applied in a splash-free manner to a printed circuit board by using a leaf-shaped liquid film, such as film $F_a$ of Figure 10, and by positioning the nozzle and circuit board such that the circuit board intercepted at least a portion of the liquid film, preferably at the approximate mid-point of the liquid film at a distance $L_a$ from the nozzle orifice where the film width $W_a$ is a maximum.

It has now been discovered that splashfree uniform thickness coatings of insulated material produced with an airless nozzle can be applied to printed circuit boards with triangular liquid films of the general type shown in Figures 4A and 4B, providing the pressure is selected such that it is equivalent to approximately 8 Kg/cm² or lower for a 125-155 cps viscosity coating, and the distances between the nozzle and substrate is approximately 20 mm or less. Preferably, the distance between the nozzle orifice and the surface of the printed circuit board to be coated with the insulated coating material is no greater than approximately two-thirds "L" where "L" is the distance between the nozzle orifice and the lower base edge of the triangular liquid film below which discrete liquid droplets of coating begin to form to produce an atomized cloud of coating material.

The results of experiments utilizing Hitachi insulative coating "Tuffy" No. 1141, an acryl type insulating material, are set forth below. In each case the speed of the nozzle relative to the substrate being coated was 213 mm per second and the coating temperature was 40°C. In examples 1, 2 and 3, the coating viscosity was 127 cps at 20°C, while in example 4, the coating viscosity was 155 cps at 20°C. In each case the percentage by weight of insulative resin with respect to the total weight of the mixture of resin and solvent material in the coating was 30%.

## EXAMPLE 1

FAN WIDTH AT SUBSTRATE

| DISTANCE (L) BETWEEN NOZZLE ORIFICE AND SUBSTRATE | | 3 mm | 5 mm | 8 mm | 10 mm | 12 mm |
|---|---|---|---|---|---|---|
| 5 mm | (a) | None | None | None | None | |
| | (b) | 7 mm | 9 mm | 11–12mm | 12–13mm | |
| | (c) | 4.5Kg/cm² | 5.0Kg/cm² | 6.7Kg/cm² | 7.8Kg/cm² | |
| | (d) | Leaf | Triangular | Triangular | Triangular | |
| 7.5mm | (a) | None | None | None | None | |
| | (b) | 9–10mm | 10–11mm | 12mm | 14–15mm | |
| | (c) | 4.8Kg/cm² | 6.0Kg/cm² | 6.8Kg/cm² | 8.0Kg/cm² | |
| | (d) | Leaf | Triangular | Triangular | Triangular | |
| 10mm | (a) | None | None | None | None | None |
| | (b) | 8mm | 9mm | 11–12mm | 13–14mm | 16–17mm |
| | (c) | 4.1Kg/cm² | 5.0Kg/cm² | 5.8Kg/cm² | 6.8Kg/cm² | 7.6Kg/cm² |
| | (d) | Leaf | Leaf | Triangular | Triangular | Triangular |
| 12.5mm | (a) | None | None | None | Two | 10 |
| | (b) | 8–9mm | 10mm | 12mm | 14mm | 17mm |
| | (c) | 4.6Kg/cm² | 5.2Kg/cm² | 6.0Kg/cm² | 6.8Kg/cm² | 7.6Kg/cm² |
| | (d) | Leaf | Leaf | Leaf | Triangular | Triangular |
| 15mm | (a) | | One | 3–4 | 10 | |
| | (b) | | 9mm | 12–13mm | 14mm | |
| | (c) | | 5.2Kg/cm² | 6.0Kg/cm² | 6.7Kg/cm² | |
| | (d) | | Leaf | Triangular | Triangular | |

Legend:
(a)   Number of splashes within 10 mm² square area immediately adjacent stripe-shaped deposit.
(b)   Insulator coating deposit width on substrate.
(c)   Fluid application pressure
(d)   Liquid film shape ("leaf" or "triangular")
Note:   Nozzle used was commercially available Nordson Corp. Part Number 712-830.

## EXAMPLE 2

FAN WIDTH AT SUBSTRATE

| DISTANCE (L) BETWEEN NOZZLE ORIFICE AND SUBSTRATE | | 5 mm | 8 mm | 10 mm | 12 mm | 15 mm | 20 mm |
|---|---|---|---|---|---|---|---|
| 5 mm | (a) | None | None | None | None | | |
| | (b) | 11-12mm | 15mm | 18mm | 22mm | | |
| | (c) | 2.4Kg/cm² | 3.5Kg/cm² | 4.5Kg/cm² | 6.0Kg/cm² | | |
| | (d) | Leaf | Triang. | Triang. | Triang. | | |
| 7.5mm | (a) | None | None | None | None | None | |
| | (b) | 12mm | 12mm | 15mm | 18mm | 20mm | |
| | (c) | 2.3Kg/cm² | 3.0Kg/cm² | 3.2Kg/cm² | 3.9Kg/cm² | 4.7Kg/cm² | |
| | (d) | Leaf | Leaf | Leaf | Triang. | Triang. | |
| 10mm | (a) | None | None | None | None | None | None |
| | (b) | 11mm | 14mm | 17mm | 19mm | 22-23mm | 26-27mm |
| | (c) | 2.1Kg/cm² | 2.7Kg/cm² | 3.4Kg/cm² | 3.7Kg/cm² | 4.8Kg/cm² | 6.3Kg/cm |
| | (d) | Leaf | Leaf | Triang. | Triang. | Triang. | Triang. |
| 12.5mm | (a) | None | None | None | None | None | None |
| | (b) | 10-11mm | 14-15mm | 17-18mm | 18-19mm | 22-23mm | 27mm |
| | (c) | 2.1Kg/cm² | 2.9Kg/cm² | 3.3Kg/cm² | 3.5Kg/cm² | 4.2Kg/cm² | 5.9Kg/cm |
| | (d) | Leaf | Leaf | Triang. | Triang. | Triang. | Triang. |
| 15mm | (a) | None | None | None | None | None | None |
| | (b) | 10mm | 13-14mm | 18-19mm | 19mm | 21mm | 25-26mm |
| | (c) | 2.2Kg/cm² | 2.8Kg/cm² | 3.4Kg/cm² | 3.4Kg/cm² | 3.9Kg/cm² | 5.0Kg/cm |
| | (d) | Leaf | Leaf | Triang. | Triang. | Triang. | Triang. |
| 20mm | (a) | None | None | None | None | None | None |
| | (b) | 11-12mm | 14-15mm | 17mm | 18-19mm | 21mm | 26-27mm |
| | (c) | 2.5Kg/cm² | 2.8Kg/cm² | 3.2Kg/cm² | 3.3Kg/cm² | 2.7Kg/cm² | 4.7Kg/cr |
| | (d) | Leaf | Leaf | Triang. | Triang. | Triang. | Triang. |

Legend:
(a)  Number of splashes within 10 mm² square area immediately adjacent stripe-shaped deposit.
(b)  Insulator coating deposit width on substrate.
(c)  Fluid application pressure
(d)  Liquid film shape ("leaf" or "triangular")
Note: Nozzle used was commercially available Nordson Corp. Part Number 150-142.

## EXAMPLE 3

| DISTANCE (L) BETWEEN NOZZLE ORIFICE AND SUBSTRATE | | FAN WIDTH AT SUBSTRATE | | | | | |
|---|---|---|---|---|---|---|---|
| | | 3 mm | 5 mm | 8 mm | 10 mm | 12 mm | 15 mm |
| 5 mm | (a) | | None | | | | |
| | (b) | | 8-10mm | 12mm | 14mm | | |
| | (c) | | 3.3Kg/cm² | 4.2Kg/cm² | 6.0Kg/cm² | | |
| | (d) | | Leaf | Triang. | Triang. | | |
| 7.5mm | (a) | None | None | None | None | None | One |
| | (b) | 8mm | 10mm | 12mm | 15mm | | 16mm |
| | (c) | 2.7Kg/cm² | 3.1Kg/cm² | 3.8Kg/cm² | 4.8Kg/cm² | | 6.0Kg/cm² |
| | (d) | Leaf | Leaf | Triang. | Triang. | Triang. | |
| 10mm | (a) | None | None | None | None | | 10 |
| | (b) | | 10mm | 11-12mm | 14mm | 16mm | 17 mm |
| | (c) | 2.6Kg/cm² | 3.0Kg/cm² | 3.6Kg/cm² | 4.5Kg/cm² | 5.1Kg/cm² | 6.0Kg/cm² |
| | (d) | Leaf | Leaf | Leaf | Triang. | | |
| 12.5mm | (a) | None | None | None | | 10-15 | 100 |
| | (b) | 8mm | 10mm | 13mm | 15mm | 15mm | 18mm |
| | (c) | 2.7Kg/cm² | 3.0Kg/cm² | 3.6Kg/cm² | 4.4Kg/cm² | 4.9Kg/cm² | 5.9Kg/cm² |
| | (d) | Leaf | Leaf | Leaf | Triang. | Triang. | |
| 15mm | (a) | None | None | None | 40-70 | | |
| | (b) | 8mm | 9-10mm | 12-13mm | 15-16mm | | |
| | (c) | 2.8Kg/cm² | 3.1Kg/cm² | 3.8Kg/cm² | 4.3Kg/cm² | | |
| | (d) | Leaf | Leaf | Leaf | Triangular | | |
| 20mm | (a) | None | 3-4 | 10 | 20 | | |
| | (b) | 9mm | 10mm | 13mm | 16mm | | |
| | (c) | 3.1Kg/cm² | 3.3Kg/cm² | 3.8Kg/cm² | 4.3Kg/cm² | | |
| | (d) | Leaf | Leaf | Leaf | Triangular | | |

Legend:
(a)  Number of splashes within 10 mm² square area immediately adjacent stripe-shaped deposit.
(b)  Insulator coating deposit width on substrate application.
(c)  Fluid application pressure.
(d)  Liquid film shape ("leaf" or "triangular").
Note:  Nozzle used was commercially available Nordson Corp. Part Number 050-022.

## EXAMPLE 4

FAN WIDTH AT SUBSTRATE

| | | | 5 mm | 8 mm | 10 mm | 12 mm | 15 mm |
|---|---|---|---|---|---|---|---|
| 5 mm | (a) | | None | None | | | |
| | (b) | | 8mm | 10mm | | | |
| | (c) | | 4.2Kg/cm² | 6.0Kg/cm² | | | |
| | (d) | | Leaf | Triangular | | | |
| 7.5mm | (a) | | None | None | None | | |
| | (b) | | 8-9mm | 12mm | 13-14mm | | |
| | (c) | | 4.0Kg/cm² | 5.8Kg/cm² | 6.7Kg/cm² | | |
| | (d) | | Leaf | Triangular | Triangular | | |
| 10mm | (a) | | None | None | None | None | |
| | (b) | | 9mm | 12mm | 13-14mm | 16mm | |
| | (c) | | 3.9Kg/cm² | 5.2Kg/cm² | 5.7Kg/cm² | 6.4Kg/cm² | |
| | (d) | | Leaf | Triangular | Triangular | Triangular | |
| 12.5mm | (a) | | None | None | None | None | |
| | (b) | | 9mm | 12mm | 13-14mm | 14-15mm | |
| | (c) | | 3.8Kg/cm² | 5.2Kg/cm² | 5.6Kg/cm² | 5.8Kg/cm² | |
| | (d) | | Leaf | Triangular | Triangular | Triangular | |
| 15mm | (a) | | None | None | one | 1-2 | 10 |
| | (b) | | 9-10mm | 13mm | 14-15mm | 16mm | 18mm |
| | (c) | | 4.0Kg/cm² | 4.9Kg/cm² | 5.5Kg/cm² | 5.8Kg/cm² | 6.9Kg/cm² |
| | (d) | | Leaf | Leaf | | | |
| 20mm | (a) | | None | 10 | 20 | 50 | |
| | (b) | | 8-9mm | 13-14mm | 16mm | 17-18mm | |
| | (c) | | 4.1Kg/cm² | 4.9Kg/cm² | 5.4Kg/cm² | 5.7Kg/cm² | |
| | (d) | | Leaf | Leaf | Triangular | Triangular | |

*Left axis label:* DISTANCE (L) BETWEEN NOZZLE ORIFICE AND SUBSTRATE

Legend:
(a)   Number of splashes within 10 mm² square area immediately adjacent stripe-shaped deposit.
(b)   Insulator coating deposit width on substrate.
(c)   Fluid application pressure
(d)   Liquid film shape ("leaf" or "triangular")
Note:   Nozzle used was commercially available Nordson Corp. part number 050-022.

As can be seen by reference to Examples 1 - 4, both leaf shaped and fan shaped liquid films were formed. Typically, the leaf-shaped films produced splashfree coatings, although occasionally under conditions where pressures were greatest and the distances between the nozzle orifice and the substrate were largest, undesirable splashing did result. For example, in Example 1 at an orifice-to-substrate distance of 15 mm and a pressure of 5.2 kg/cm², one splash was noted with a leaf-shaped pattern. In Example 2, all leaf-shaped patterns produced splashfree results. In example 3, splashfree results with a leaf-shaped pattern did not result at nozzle orifice-to-substrate distances of 20 mm at pressures of 3.3 Kg/cm² and 3.8 Kg/cm². In Example 4, splashfree results with a leaf-shaped pattern did not result at a substrate-to-orifice distance of 20 mm at a pressure of 4.9 Kg/cm².

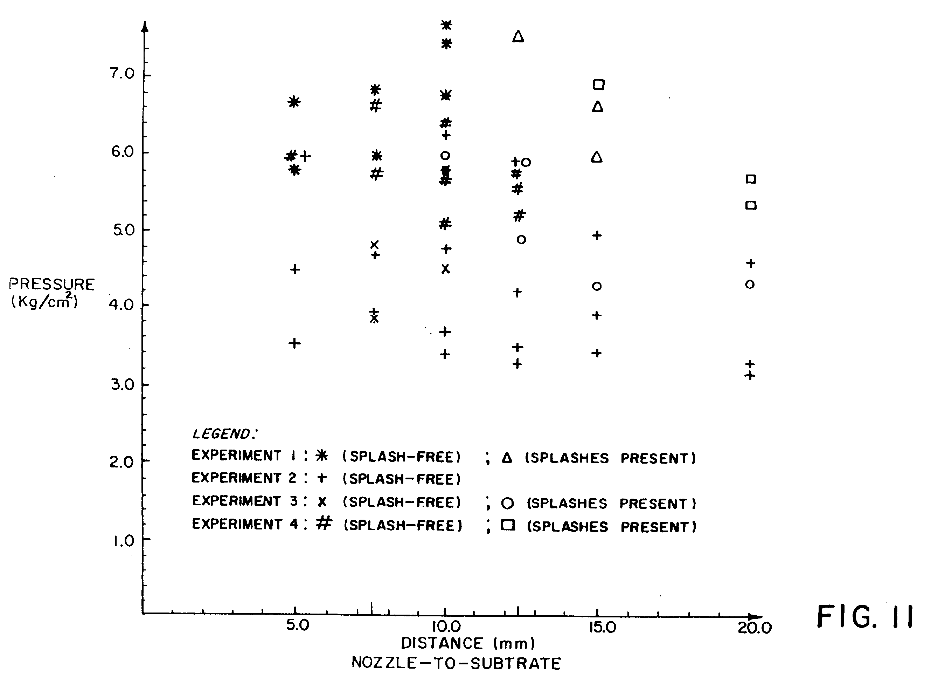

With reference to Example 1 - 4, it will also be observed that in most instances triangular-shaped films also produced splashfree insulative coatings on the substrate. In Example 2, all of the triangular shaped liquid films showed splashfree results. In Examples 1, 3 and 4, splashfree results with triangular liquid films tended to decrease as the combination of pressure and orifice-to-substrate distance increased. This tendency is apparent from Fig. 11, which is a plot of the results, splashfree or splashes present, for different triangular liquid films produced at varying combinations of liquid application pressure of the airless nozzle (vertical axis) and airless nozzle orifice-to-substrate distance (horizontal axis). At nozzle-to-substrate distances of 10 mm and below, in accordance with the method of this invention, splash-free coatings with triangular films resulted regardless of the pressure up to pressures of approaching 8 Kg/cm². At nozzle-to-substrate distances of 12.5 mm, splash-free results with triangular films generally occurred, although not always, at pressures of 6 Kg/cm² or less. At 15 mm to 20 mm nozzle-to-substrate distances, splashfree results with triangular films occurred when the pressure was reduced below 5 Kg/cm².

While described in connection with triangular liquid films produced with insulative coatings of specific viscosities (125 cps-155 cops at 20°C) which were subjected to varying application pressures in the approximate 3 - 8 Kg/cm² range, those skilled in the art will appreciate that triangular liquid films can be produced with coating materials of different viscosity.

Those skilled in the art will appreciate that for a given coating material as the viscosity is reduced (increased), the pressure required to produce a triangular liquid film for splashfree substrate coating purposes will correspondingly be reduced (increased).

The details of construction of the airless spray nozzle Nf, which is more particularly shown in Fig. 5, forms no part of this invention. An airless spray nozzle of the type disclosed in Boone U.S. patent 4,337,281, granted June 29, 1982, can be used to form the dovetail or triangular-shaped liquid film F in accordance with the method of this invention.

## Claims

1. A method of applying moistureproof insulative coating to selected areas of a circuit board without applying insulative coating to regions to be left uncoated, comprising supplying insulative liquid coating material to a flat-pattern nozzle means at a supply pressure such as to produce a liquid film emission from the nozzle means in a flat pattern, positioning the nozzle means and circuit board at a specified distance apart relative to each other to position the circuit board in the path of the flat pattern, producing relative movement between the nozzle means and circuit board in a direction generally transverse to the plane of the flat pattern, and controlling the liquid coating supply during relative movement between the nozzle means and circuit board to a) supply liquid to the nozzle means when the flat pattern is directed toward the selected areas to be coated to impinge a flat liquid film thereon and thereby coat the areas to be coated, and b) interrupt the supply of liquid to the nozzle means when the flat pattern is directed toward the regions to be left uncoated to terminate emission of the flat liquid film and prevent deposit thereof on the regions to be left uncoated characterised in that the insulative liquid coating material is supplied to the nozzle means at a supply pressure up to 8 kg/cm² so that the flat pattern of the liquid film emission has a generally triangular shape with a lower horizontal base edge and an upper apex, which has a maximum width W at its lower base edge below which discrete liquid droplets of coating begin to form, and which decreases in width to an approximately zero width at a distance L above the lower base edge, the triangular shaped liquid film being substantially free of atomised particles of coating and in that the specified distance between the nozzle means and the circuit board does not exceed a distance of approximately 2/3 L.

2. A method as claimed in Claim 1, wherein the nozzle means and circuit board are spaced apart a distance of approximately 20 mm or less.

3. A method as claimed in either Claim 1 or Claim 2, wherein the nozzle means and circuit board are spaced apart a distance of approximately 15 mm or less and the insulative coating material is supplied at a pressure below approximately 5 kg/cm² for a coating viscosity of approximately 125-155 cps at 20 °C.

4. A method as claimed in either Claim 1 or Claim 2 wherein the nozzle means and circuit board are spaced apart a distance of approximately 12.5 mm or less and the insulative coating material is supplied at a pressure below approximately 6 kg/cm² for a coating viscosity of 125-155 cps at 20 °C.

5. A method as claimed in either Claim 1 or Claim 3 wherein the nozzle means and circuit board are spaced apart a distance of approximately 10 mm or less and the insulative coating material is supplied at a pressure below approximately 8kg/cm² for a coating viscosity of 125-155 cps at 20 °C.

**Patentansprüche**

1. Verfahren zum Aufbringen einer feuchtigkeitsdichten isolierenden Beschichtung auf ausgewählte Bereiche einer Leiterplatte ohne Aufbringen der isolierenden Beschichtung auf die unbeschichtet zu belassenden Zonen, umfassend,

Zuführen von isolierendem flüssigen Beschichtungsmaterial zu einem flach-formenden Düsenmittel mit einem solchen Speisedruck, daß ein Ausströmen eines Flüssigkeitsfilms aus dem Düsenmittel in einer Flächenstruktur erzeugt wird,

Positionieren des Düsenmittels und der Leiterplatte in einem vorgegebenen Abstand entfernt voneinander, um die Leiterplatte in der Bahn der Flächenstruktur zu positionieren,

Erzeugen einer relativen Bewegung zwischen dem Düsenmittel und der Leiterplatte in eine Richtung, die meistens quer zu der Ebene der Flächenstruktur ist, und

Steuern der Zuführung der flüssigen Beschichtung während der relativen Bewegung zwischen dem Düsenmittel und der Leiterplatte um a) Flüssigkeit zu dem Düsenmittel zuzuführen, wenn die Flächenstrukturauf die ausgewählten, zu beschichtenden Bereiche gerichtet ist, damit ein flacher Flüssigkeitsfilm darauf auftrifft und dabei die zu beschichtenden Bereiche überzieht, und b) die Zuführung von Flüssigkeit zu dem Düsenmittel zu unterbrechen, wenn die Flächenstruktur auf die unbeschichtet zu belassenden Zonen gerichtet ist, um das Ausströmen des flachen Flüssigkeitsfilmes zu beenden und dessen Ablagerung auf den unbeschichtet zu belassenden Zonen zu verhindern, dadurch gekennzeichnet, daß das isolierende flüssige Beschichtungsmaterial dem Düsenmittel mit einem Speisedruck bis zu 8 Kg/cm² zugeführt wird, so daß die Flächenstruktur des ausströmenden Flüssigkeitsfilms eine meistens dreieckige Form mit einer unteren horizontalen Basiskante und eine obere Spitze hat, die eine maximale Breite W an ihrer unteren Basiskante hat, unterhalb derer sich einzelne Flüssigkeitströpfchen der Beschichtung zu bilden beginnen, und die sich in der Breite bis auf eine ungefähre Null-Breite in einem Abstand L über der unteren Basiskante verkleinert, wobei der dreieckig geformte Flüssigkeitsfilm im wesentlichen frei von atomisierten Partikeln der Beschichtung ist, und daß der vorgegebene Abstand zwischen dem Düsenmittel und der Leiterplatte einen Abstand von ungefähr $\frac{2}{3}$ L nicht überschreitet.

2. Verfahren nach Anspruch 1, bei dem das Düsenmittel und die Leiterplatte in einem Abstand von ungefähr 20 mm oder weniger voneinander entfernt angeordnet sind.

3. Verfahren nach einem der Ansprüche 1 oder 2, bei dem das Düsenmittel und die Leiterplatte in einem Abstand von ungefähr 15 mm oder weniger voneinander entfernt angeordnet sind und das isolieren- de Beschichtungsmaterial mit einem Druck unter ungefähr 5 kg/cm² für eine Beschichtungsviskosität von ungefähr 125-155 cps bei 20°C zugeführt wird.

4. Verfahren nach einem der Ansprüche 1 oder 2, bei dem das Düsenmittel und die Leiterplatte in einem Abstand von ungefähr 12,5 mm oder weniger voneinander entfernt angeordnet sind und das isolierende Beschichtungsmaterial mit einem Druck unter ungefähr 6 kg/cm² für eine Beschichtungsviskosität von 125-155 cps bei 20°C zugeführt wird.

5. Verfahren nach einem der Ansprüche 1 oder 3, bei dem das Düsenmittel und die Leiterplatte in einem Abstand von ungefähr 10 mm oder weniger voneinander entfernt angeordnet sind und das isolierende Beschichtungsmaterial mit einem Druck unter ungefähr 8 kg/cm² für eine Beschichtungsviskosität von 125-155 cps bei 20°C zugeführt wird.

**Revendications**

1. Procédé d'application d'un revêtement isolant à l'épreuve de l'humidité sur des zones sélectionnées d'une carte imprimée, sans appliquer de revêtement isolant aux régions destinées à rester nues, comprenant l'alimentation d'une buse à jet plat en matériau de revêtement isolant liquide, selon une pression d'alimentation telle qu'elle produise une émission de nappe liquide émanant de la buse en un jet plat, le positionnement de la buse et de la carte imprimée à une distance spécifiée l'une par rapport à l'autre, afin de positionner la carte imprimée dans la trajectoire du jet plat, la production d'un mouvement relatif entre la buse et la carte imprimée, dans un sens globalement transversal au plan du jet plat, et le contrôle de l'alimentation en revêtement liquide lors du mouvement relatif entre la buse et la carte imprimée afin a) d'alimenter la buse en liquide lorsque le jet plat est dirigé en direction des zones sélectionnées pour être recouvertes, afin d'appliquer une nappe liquide plate sur celles-ci et revêtir ainsi les zones destinées à être recouvertes et b) d'interrompre l'alimentation de la buse en liquide lorsque le jet plat est dirigé en direction des zones destinées à rester nues, afin d'interrompre l'émission de la nappe liquide plate et d'empêcher son dépôt sur les zones destinées à rester nues, caractérisé en ce que le matériau de revêtement isolant liquide est alimenté dans la buse selon une pression allant jusqu'à 8 kg/cm$^2$, de telle sorte que le jet plat, lors de l'émission de la nappe liquide, ait une forme globalement triangulaire, avec un bord de base horizontal inférieur et un sommet supérieur, présentant une largeur maximum W, au niveau de son bord de base inférieur, en-dessous de laquelle des gouttes liquides discrètes de revêtement commencent à se former, et dont la largeur va en décroissant jusqu'à une largeur approximativement égale à zéro, à une distance L au-dessus du bord de base inférieur, la nappe liquide de forme triangulaire étant sensiblement dépourvue de particules atomisées de revêtement, et en ce que la carte imprimée ne dépasse pas une distance d'environ 2/3 L.

2. Procédé selon la revendication 1, dans lequel la buse et la carte imprimée sont espacés selon une distance d'environ 20 mm ou moins.

3. Procédé selon la revendication 1 ou la revendication 2, dans lequel la buse et la carte imprimée sont espacés selon une distance d'environ 15 mm ou moins et le matériau de revêtement isolant est alimenté à une pression située en-dessous d'approximativement 5 kg/cm$^2$, pour une viscosité de revêtement d'environ 125-155 cps à 20°C.

4. Procédé selon la revendication 1 ou la revendication 2, dans lequel la buse et la carte imprimée sont espacés selon une distance d'environ 12,5 mm ou moins et le matériau de revêtement isolant est alimenté à une pression située en-dessous d'approximativement 6 kg/cm$^2$, pour une viscosité de revêtement d'environ 125-155 cps à 20°C.

5. Procédé selon la revendication 1 ou la revendication 3, dans lequel la buse et la carte imprimée sont espacés selon une distance d'environ 10 mm ou moins et le matériau de revêtement isolant est alimenté à une pression située en-dessous d'approximativement 8 kg/cm$^2$, pour une viscosité de revêtement d'environ 125-155 cps à 20°C.

FIG.1

FIG. 2

FIG. 3

FIG. 4A

FIG. 4B

FIG. 5

100 CPS – 50 kg/cm²
(50 CPS – 35 kg/cm²)

FIG. 6

100 CPS – 20 kg/cm²
(50 CPS – 12 kg/cm²)

FIG. 7

100 CPS – 10 kg/cm²
(50 CPS – 5 kg/cm²)

FIG. 8

100 CPS – 5 kg/cm²
(50 CPS – 3 kg/cm²)

FIG. 9

FIG. 10A

FIG. 10B

FIG. II

EP 0 347 058 B1